# EUROPEAN PATENT APPLICATION

(11) **EP 3 128 567 A1**
(43) Date of publication of application: **08.02.2017**
(21) Application number: 16153884.8
(22) Date of filing: 02.02.2016
(51) Int. Cl.: H01L 45/00

(54) **RESISTIVE RANDOM ACCESS MEMORY**

(30) Priority: 03.08.2015 CN 201510479381
(71) Applicant: Winbond Electronics Corp., Taichung City, Taiwan. (TW)
(72) Inventor: Tseng, Tseung-Yuen, Taiwan (R.O.C) (TW); Lan, Shun-Li, Taiwan (R.O.C) (TW); Chang, Hsiang-Yu, Taiwan (R.O.C) (TW); Lin, Chun-An, Taiwan (R.O.C) (TW)
(74) Representative: Chamberlain, Alan James

(57) **Abstract**

A resistive random access memory (RRAM) element (100) including a substrate (110), a conductive layer (120), a resistive switching layer (130), a copper-containing oxide layer (140), and an electron supply layer (150) is provided. In a preferred embodiment, a CuTi/CuOx/SiNx layer structure is deposited on a Pt or TiN/Au/Ti bottom electrode overlying an oxidised Si substrate.

## Description

### BACKGROUND OF THE INVENTION

### Field of the Invention

The invention relates to a non-volatile memory, and more particularly, to a resistive random access memory.

### Description of Related Art

A non-volatile memory has the advantage of retaining data after being powered off. Therefore, many electronic products require the non-volatile memory to maintain normal operation when the electronic products are turned on. Currently, one non-volatile memory device actively developed by industries is a resistive random access memory (RRAM), and the RRAM has advantages such as low write-in operation voltage, short write-in and erase time, long memory time, non-destructive reading, multi-state memory, simple structure, and small required area. As a result, the RRAM has the potential to become one of the widely adopted non-volatile memory devices in personal computers and electronic equipment in the future. However, how to further increase the data retention capability of the resistive non-volatile memory is a current object actively pursued by industries.

### SUMMARY OF THE INVENTION

The invention provides a resistive random access memory capable of having better data retention capability.

The invention provides a resistive random access memory including a substrate, a conductive layer, a resistive switching layer, a copper-containing oxide layer, and an electron supply layer. The conductive layer is disposed on the substrate. The resistive switching layer is disposed on the conductive layer. The copper-containing oxide layer is disposed on the resistive switching layer. The electron supply layer is disposed on the copper-containing oxide layer.

Based on the above, in the resistive random access memory provided in the invention, in a low resistance state, the electron supply layer can provide electrons to inhibit the spreading of copper filaments, such that the resistive random access memory can have better data retention capability. Moreover, the electron supply layer in the resistive random access memory can also be used to capture oxygen to stop oxygen from spreading to the atmosphere, such that the resistive random access memory can have better endurance.

Several exemplary embodiments accompanied with figures are described in detail below to further describe the disclosure in details.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 is a cross-sectional schematic of a resistive random access memory (RRAM) of an embodiment of the invention.
FIG. 2 is a cross-sectional schematic of an RRAM of another embodiment of the invention.
FIG. 3 is a graph of the relationship between operating voltage and current of sample 1 in a copper filament forming process.
FIG. 4 is a graph of the relationship between operating voltage and current of sample 2 in a copper filament forming process.
FIG. 5 is a graph of the electrical property of resistive switching of sample 1.
FIG. 6 is a graph of the electrical property of resistive switching of sample 2.
FIG. 7 is a graph of the relationship between current and number of resistive switching of sample 1 in an endurance test.
FIG. 8 is a graph of the relationship between current and number of resistive switching of sample 2 in an endurance test.
FIG. 9 is a graph of the relationship between current and time of sample 2 in a data retention capability test under a temperature of 85°C.
FIG. 10 is a graph of the relationship between current and time of sample 2 in a data retention capability test under a temperature of 200°C.
FIG. 11 shows the relationship of oxygen element distribution in a resistive random access memory, wherein the picture in FIG. 11 is a transmission electron microscopy (TEM) micrograph of sample 2 at room temperature, and the graph in FIG. 11 shows the oxygen element distribution ratio obtained alter an analysis of sample 2 at room temperature via an X-ray Photoelectron Spectrometer.
FIG. 12 shows the relationship of oxygen element distribution in a resistive random access memory, wherein the picture in FIG. 12 is a TEM micrograph of sample 2 after a heating test, and the graph in FIG. 12 shows the oxygen element distribution ratio obtained after an analysis of sample 2 after a heating test via an X-ray Photoelectron Spectrometer.

### DESCRIPTION OF THE EMBODIMENTS

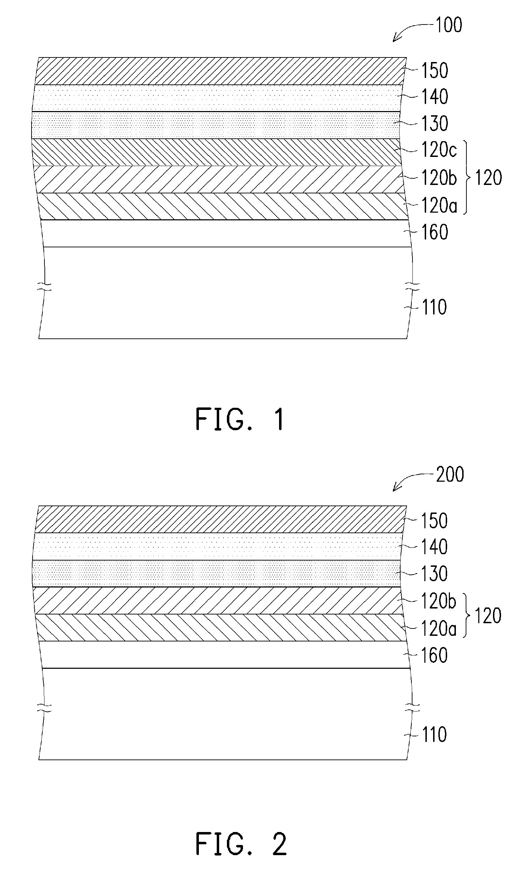

Referring to FIG. 1, a resistive random access memory 100 includes a substrate 110, a conductive layer 120, a resistive switching layer 130, a copper-containing oxide layer 140, and an electron supply layer 150. The substrate 110 is, for instance, a semiconductor substrate such as a silicon substrate.

The conductive layer 120 is disposed on the substrate 110, and can be used as a lower electrode of the resistive random access memory 100. The conductive layer 120 can be a single-layer structure or a multi-layer structure. In the present embodiment, the conductive layer 120 is exemplified as a multi-layer structure, but the invention is not limited thereto. For instance, the conductive layer 120 can include a conductive layer 120a, a conductive layer 120b, and a conductive layer 120c. The material of the conductive layer 120 is, for instance, titanium, titanium nitride, white gold, aluminum, tungsten, iridium, iridium oxide, ruthenium, tantalum, tantalum nitride, nickel, molybdenum, zirconium, indium tin oxide, or a doped semiconductor (such as doped polysilicon). The thickness of the conductive layer 120 is, for instance, 1 nanometer to 500 nanometers. The forming method of the conductive layer 120 is, for instance, an AC magnetron sputtering method, an atomic layer deposition method, or an electron beam vapor deposition method.

The resistive switching layer 130 is disposed on the conductive layer 120. The material of the resistive switching layer 130 is, for instance, hafnium (IV) oxide, aluminum oxide, titanium dioxide, zirconium dioxide, tin oxide, zinc oxide, aluminum nitride, or silicon nitride. The thickness of the resistive switching layer 130 is, for instance, 1 nanometer to 100 nanometers. The forming method of the resistive switching layer 130 is, for instance, a plasma-enhanced chemical vapor deposition method, an atomic layer deposition method, an AC magnetron sputtering method, of an electron beam vapor deposition method. The deposition temperature range of the resistive switching layer 130 is, for instance, 100 °C to 500 °C. Moreover, an annealing treatment can be performed on the resistive switching layer 130 by using a high-temperature furnace tube. Moreover, when the material of the resistive switching layer 130 adopts a material having a dense structure such as silicon nitride, hafnium (IV) oxide, or aluminum oxide, spreading of copper filaments in the resistive switching layer 130 can be inhibited, such that the resistive random access memory 100 of the invention can have better data retention capability.

The copper-containing oxide layer 140 is disposed on the resistive switching layer 130. The material of the copper-containing oxide layer 140 is, for instance, copper titanium oxide, copper tantalum oxide, copper aluminum oxide, copper cobalt oxide, copper tungsten oxide, copper iridium oxide, copper ruthenium oxide, copper nickel oxide, copper molybdenum oxide, copper zirconium oxide, or indium tin copper oxide. The thickness of the copper-containing oxide layer 140 is, for instance, 1 nanometer to 100 nanometers. The forming method of the copper-containing oxide layer 140 is, for instance, an AC magnetron sputtering method or an electron beam vapor deposition method. The copper-containing oxide layer 140 can provide copper ions for resistive switching.

When positive bias is applied to the electron supply layer 150 of the resistive random access memory 100, copper ions in the copper-containing oxide layer 140 are reduced to copper atoms in the resistive switching layer 130 to form copper filaments, such that the resistance value of the resistive random access memory 100 is reduced and the resistive random access memory 100 is in a low resistance state (LRS). When negative bias is applied to the electron supply layer 150 of the resistive random access memory 100, copper atoms in the copper filaments are oxidized into copper ions, thus causing breaking of the copper filaments, such that the resistance value of the resistive random access memory 100 is increased and the resistive random access memory 100 is in a high resistance state (HRS).

The electron supply layer 150 is disposed on the copper-containing oxide layer 140. The material of the electron supply layer 150 is, for instance, a copper-titanium alloy, copper titanium nitride, a copper-aluminum alloy, a copper-tungsten alloy, a copper-iridium alloy, copper iridium oxide, a copper-ruthenium alloy, a copper-tantalum alloy, copper tantalum nitride, a copper-nickel alloy, a copper-molybdenum alloy, a copper-zirconium alloy, or indium tin copper oxide. The thickness of the electron supply layer 150 is, for instance, 1 nanometer to 1000 nanometers. The forming method of the electron supply layer 150 is, for instance, an AC magnetron sputtering method, an atomic layer deposition method, or an electron beam vapor deposition method.

The main functions of the electron supply layer 150 are described below. When the resistive random access memory 100 is in a low resistance state, copper filaments formed by copper atoms are spread outward with time. The electron supply layer 150 can provide electrons to the copper filaments so as to inhibit the spreading of the copper filaments, such that the resistive random access memory 100 can have better data retention capability. Moreover, the electron supply layer 150 can also be used to capture oxygen, such that a redox reaction can be continuously performed, so that the resistive random access memory 100 of the invention can have better endurance. Moreover, the electron supply layer 150 can also be used as an upper electrode layer of the resistive random access memory 100.

Moreover, the resistive random access memory 100 can further include a dielectric layer 160. The dielectric layer 160 is disposed between the substrate 110 and the conductive layer 120. The material of the dielectric layer 160 is, for instance, a dielectric material such as silicon oxide, silicon nitride, or silicon oxynitride. The thickness of the dielectric layer 160 is, for instance, 3 nanometers to 10 nanometers. The forming method of the dielectric layer 160 is, for instance, a thermal oxidation method or a chemical vapor deposition method.

It can be known from the above embodiments that, in the resistive random access memory 100, the copper-containing oxide layer 140 can provide copper ions to form copper filaments, such that the resistive random access memory 100 is in a low resistance state. In the low resistance state, the electron supply layer 150 can provide electrons to inhibit the spreading of the copper filaments, such that the resistive random access memory 100 can have better data retention capability. Moreover, the electron supply layer 150 in the resistive random access memory 100 can also be used to capture oxygen to stop oxygen from spreading to the atmosphere, such that the resistive random access memory 100 can have better endurance.

Referring to both FIG. 1 and FIG. 2, the difference between a resistive random access memory 200 of FIG. 2 and the resistive random access memory 100 of FIG. 1 is: the conductive layer 120 of the resistive random access memory 200 of FIG. 2 is a two-layer structure. Specifically, in the resistive random access memory 200, the conductive layer 120 includes a conductive layer 120a and a conductive layer 120b. Moreover, the method of disposition, the material, the forming method, and the efficacy of the other members of the resistive random access memory 200 of FIG. 2 are similar to those of the resistive random access memory 100 of FIG. 1, and the members are therefore represented by the same reference numerals and are not repeated herein.

### Experimental Examples

In the following, the properties of the resistive random access memory of the present embodiment are more specifically described via experimental examples. In the following experimental examples, sample 1 has the structure of the resistive random access memory 100 of FIG. 1, and sample 2 has the structure of the resistive random access memory 200 of FIG. 2. First, the manufacturing methods and relevant parameter conditions of sample 1 and sample 2 are described, but the manufacturing method of the resistive random access memory of the invention is not limited thereto.

### Sample 1:

A silicon substrate washed with an RCA (Radio Corporation of America) cleaning step was provided as the substrate 110. Then, a 200 nm-thick silicon dioxide thin film was grown on the substrate 110 by using a high-temperature furnace tube as the dielectric layer 160. Then, a 15 nm-thick titanium thin film and a 30 nm-thick white gold thin film were grown on the dielectric layer 160 via an electron beam vapor deposition method to be respectively used as the conductive layer 120a and the conductive layer 120b, wherein the conductive layer 120b (white gold thin film) can be adhered on the dielectric layer 160 via the conductive layer 120a (titanium thin film) in a stable manner. Then, by using an atomic layer deposition method, tetrakis(dimethylamido)titanium (Ti[N(CH₃)₂]₄; TDMAT) is used as a precursor and is reacted with nitrogen plasma, and 10 nm of a titanium nitride thin film used as the conductive layer 120c was grown on the conductive layer 120b in an environment of a deposition temperature of 250 °C and a working pressure of 0.3 Torr. Then, via a plasma-enhanced chemical vapor deposition method, a silicon nitride thin film used as the resistive switching layer 130 was deposited on the conductive layer 120c in an environment of a deposition temperature of 300 °C and a working pressure of 1.3 Torr by using SiH₄ and NH₃ as reaction gases and using Ar plasma to increase reaction rate. Then, in a vacuum environment, a copper thin film was deposited on the resistive switching layer 130 via an AC magnetron sputtering method in an oxygen atmosphere to form an oxygen-doped copper thin film used as the copper-containing oxide layer 140. Then, the oxygen atmosphere was turned off, and a copper-titanium alloy thin film used as the electron supply layer 150 was grown on the copper-containing oxide layer 140 to complete the manufacture of sample 1.

### Sample 2:

The difference between sample 2 and sample 1 is as follows: the conductive layer 120 of sample 2 is a two-layer structure. Specifically, in sample 2, the conductive layer 120 includes the conductive layer 120a and the conductive layer 120b. Moreover, sample 2 was patterned into a cross-bar pattern having an area of 2x2 µm² via a lithography process and an etching process. Moreover, the method of disposition, the material, and the forming method of the other members of sample 2 are similar to those of sample 1, and are therefore not repeated herein.

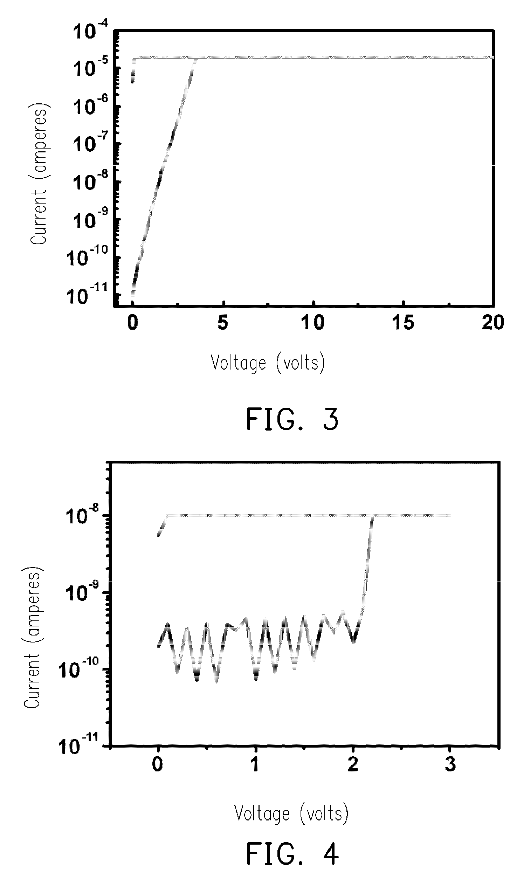

Referring to FIG. 3, a positive polarity bias is applied to the electron supply layer 150 in sample 1. At this point, the conductive layer 120c is grounded through the conductive layer 120b. When the voltage is increased, the current is also increased. When the current is increased to the limited current value (20 µA), the bias value of 3.4 V at this point is a forming voltage in the forming of copper filaments. Then, the bias still needs to be increased to complete resistive switching, such that the resistance value of the resistive random access memory is switched from an initial high resistance state (HRS) to a low resistance state (LRS).

Referring to FIG. 4. A positive polarity bias is applied to the electron supply layer 150 in sample 2. At this point, the conductive layer 120b is grounded. When the voltage is increased, the current is also increased. When the current is increased to the limited current value (10 nA), the bias of 2.2 V at this point is a forming voltage. Then, the bias still needs to be increased to complete resistive switching, such that the resistance value of the resistive random access memory is switched from an initial high resistance state (HRS) to a low resistance state (LRS).

It can be known from FIG. 3 and FIG. 4 that, in comparison to sample 1 having a greater area, sample 2 having a smaller area has a lower limit current value.

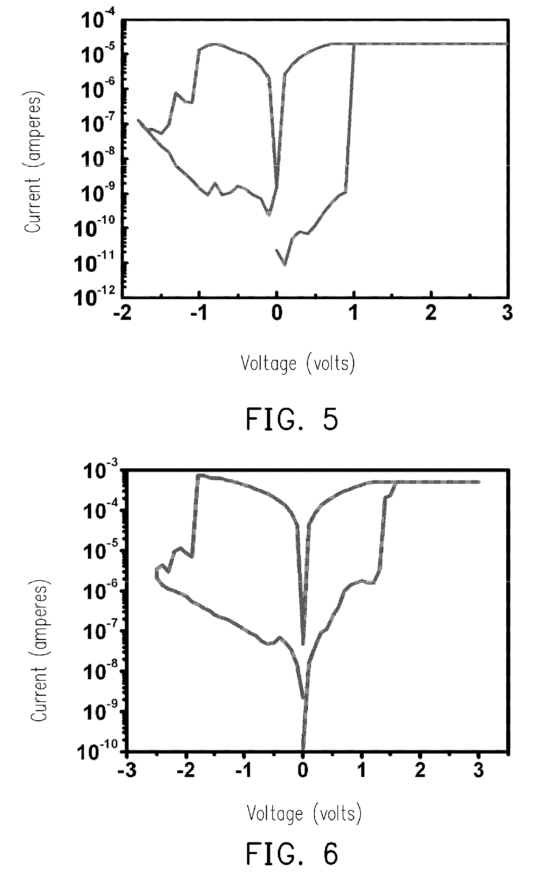

Referring to FIG. 5, a positive DC bias is applied to the electron supply layer 150 in sample 1. When a bias is applied from 0 V to 1 V, the current value begins to increase, and this phenomenon shows that the resistance value of sample 1 is reduced with an increase in the positive bias. After the positive bias is continuously applied until 3 V, the applied bias is returned from 3 V to 0 V, and it is seen that the voltage-current curve (I-V curve) of a bias from 0 V to 1 V does not overlap with the I-V curve of a bias in the opposite direction from 1 V to 0 V. This phenomenon shows that resistive switching has occurred. That is, the high resistance state is switched to low resistance state. Then, a negative DC bias is applied on the electron supply layer 150, and when the applied bias changes from 0 V to -1 V, the current value begins to increase, and this phenomenon shows that the resistance value of sample 1 is reduced with an increase in the negative bias. When the negative bias is continuously applied until -1 V, the current value of sample 1 is reduced for the first time, and then the negative bias is continuously increased to -2 V, and the current value continues to decrease. Then, the applied bias is increased from -2 V to 0 V, and it is seen that the voltage-current curve (1-V curve) of a bias from 0 V to -2 V does not overlap with the I-V curve of a bias in the opposite direction from -2 V to 0 V. This phenomenon shows that sample 1 is switched from a low resistance state to a high resistance state.

Referring to FIG. 6, a positive DC bias is applied on the electron supply layer 150 in sample 2. When a bias is applied from 0 V to 1.6 V, the current value begins to increase, and this phenomenon shows that the resistance value of sample 2 is reduced with an increase in the positive bias. After the positive bias is continuously applied until 3 V, the applied bias is returned from 3 V to 0 V, and it is seen that the voltage-current curve (I-V curve) of a bias from 0 V to 1.6 V does not overlap with the I-V curve of a bias in the opposite direction from 1.6 V to 0 V. This phenomenon shows that resistive switching has occurred. That is, the high resistance state is switched to low resistance state. Then, a negative DC bias is applied on the electron supply layer 150, and when the applied bias changes from 0 V to -1.8 V, the current value begins to increase, and this phenomenon shows that the resistance value of sample 2 is reduced with an increase in the negative bias. When the negative bias is continuously applied until -1.8 V, the current value of sample 2 is reduced for the first time, and then the negative bias is continuously increased to -2.5 V, and the current value continues to decrease. Then, the applied bias is increased from -2.5 V to 0 V, and it is seen that the voltage-current curve (I-V curve) of a bias from 0 V to -2.5 V does not overlap with the I-V curve of a bias in the opposite direction from -2.5 V to 0 V. This phenomenon shows that sample 2 is switched from a low resistance state to a high resistance state.

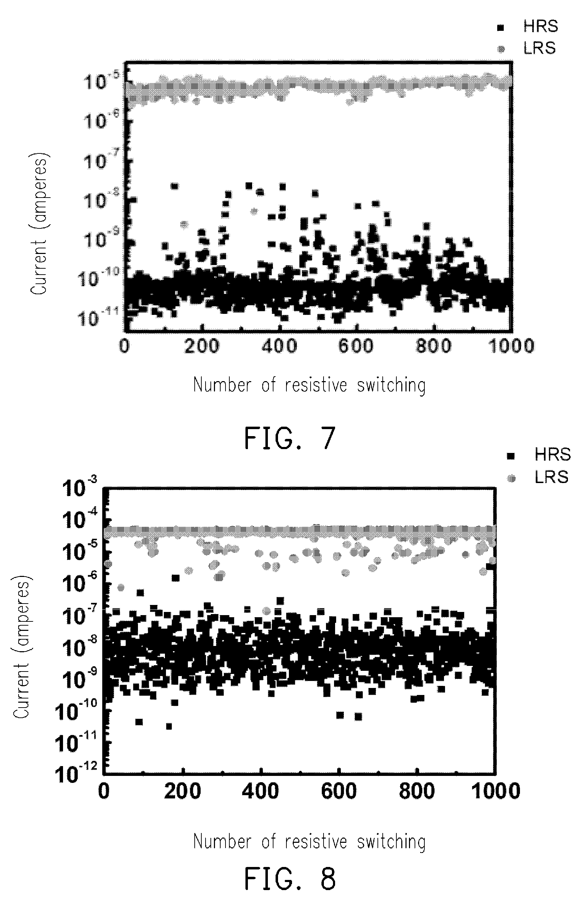

Referring to FIG. 7, a bias is applied on the electron supply layer 150 in sample 1, and the conductive layer 120c is grounded via the conductive layer 120b, wherein the current values of the high resistance state and the low resistance state are both read under a bias of 0.3 V. Under over 1000 continuous switching operations, the resistance ratio values between the high resistance state and the low resistance state are still greater than 200. It can therefore be known that, sample 1 has excellent endurance.

Referring to FIG. 8, a bias is applied on the electron supply layer 150 in sample 2, and the conductive layer 120b is grounded, wherein the current values of the high resistance state and the low resistance state are both read under a bias of 0.1 V. Under over 1000 continuous switching operations, the resistance ratio values between the high resistance state and the low resistance state are still greater than 10. It can therefore be known that, simple 2 has excellent endurance.

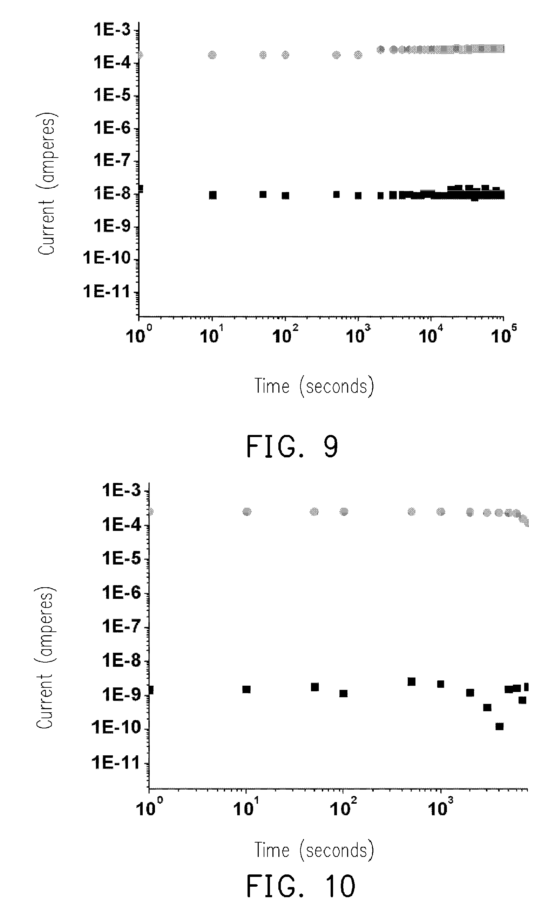

Referring to FIG. 9, sample 2 is respectively switched to a low resistance state and a high resistance state via the erasing and writing voltage values in the experimental example of FIG. 6. Then, the current values under low resistance state and high resistance state are periodically read with a voltage of 0.3 V under the low resistance state and the high resistance state. The test results show that after sample 2 is placed under a temperature of 85°C for 10⁵ seconds, data can still be read correctly without the generation of any memory characteristic degradation. Moreover, a resistance ratio value between the high resistance state and the low resistance state is greater than 10³,

Referring to FIG. 10, sample 2 is respectively switched to a low resistance state and a high resistance state via the erasing and writing voltage values in the experimental example of FIG. 6. Then, the current values under low resistance and high resistance memory states are periodically read with a voltage of 0.3 V under the low resistance state and the high resistance state. The test result shows that sample 2 can maintain a memory state for up to 8 × 10³ seconds under a temperature of 200 °C. Moreover, a resistance ratio value between the high resistance state and the low resistance state is greater than 10⁴.

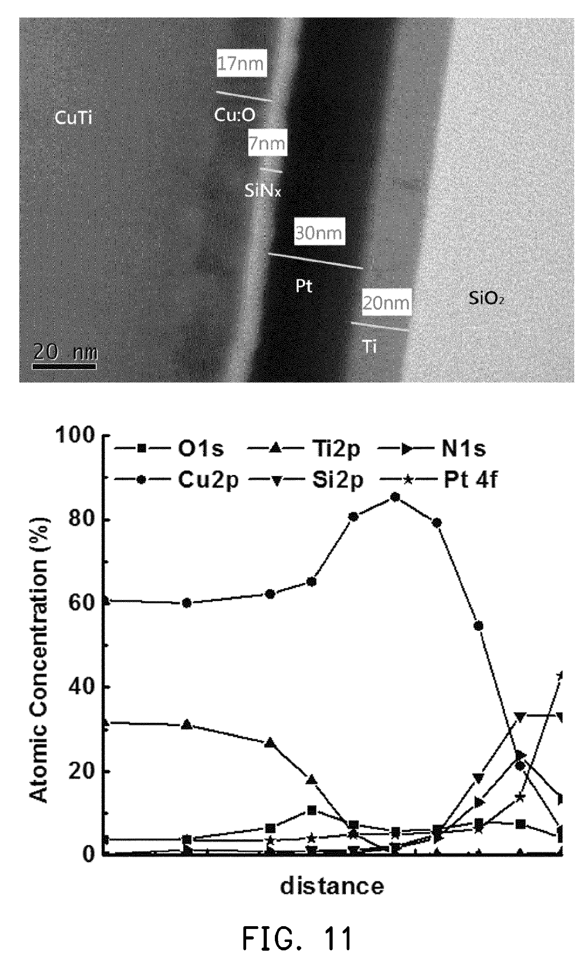

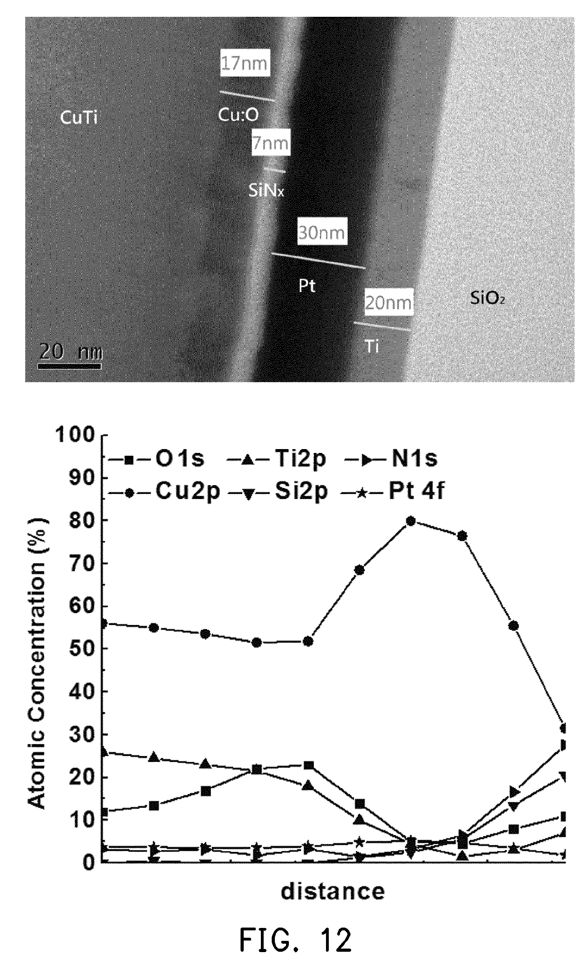

The picture in FIG. 11 is a TEM micrograph of sample 2 at room temperature, and the graph in FIG. 11 shows the oxygen element distribution ratio obtained after analysis of sample 2 via an X-ray Photoelectron Spectrometer at room temperature. The picture in FIG. 12 is a TEM micrograph of sample 2 after a heating test, and the graph in FIG. 12 shows the oxygen element distribution ratio after analysis of sample 2 after a heating test via an X-ray Photoelectron Spectrometer.

Referring to FIG. 11, before the copper filament forming of sample 2, images of the electron supply layer 150, the copper-containing oxide layer 140, and the resistive switching layer 130 in sample 2 are obtained by using a transmission electron microscope, and an oxygen element ratio analysis is performed on the electron supply layer 150, the copper-containing oxide layer 140, and the resistive switching layer 130 in sample 2 by using an X-ray Photoelectron Spectrometer. The analysis results show that the peak value of oxygen element ratio at the interface of the electron supply layer 150 and the copper-containing oxide layer 140 is 10.83 %.

Referring to FIG. 12, after accelerated tests of sample 2 at different temperatures (maximum temperature of 200 °C), sample 2 is automatically switched from a low resistance state to a high resistance state. Then, images of the electron supply layer 150, the copper-containing oxide layer 140, and the resistive switching layer 130 in sample 2 are obtained by using a transmission electron microscope, and an oxygen element ratio analysis is performed on the electron supply layer 150, the copper-containing oxide layer 140, and the resistive switching layer 130 in sample 2 by using an X-ray Photoelectron Spectrometer. The analysis results show that the peak value of oxygen element ratio at the interface of the electron supply layer 150 and the copper-containing oxide layer 140 at which the oxygen element is distributed is 23.23 %.

It can be known from the results of FIG. 11 and FIG. 12 that, after high-temperature accelerated testing, the oxygen element increase ratio at the interface of the electron supply layer 150 and the copper-containing oxide layer 140 is 114 %, thus indirectly proving that the electron supply layer 150 does have the effect of capturing oxygen and can effectively inhibit the oxygen escaping phenomenon in the copper-containing oxide layer 140. As a result, the endurance of the resistive random access memory can be effectively increased.

Based on the above, the resistive random access memory of the above embodiments at least has the following characteristics. The electron supply layer in the resistive random access memory can provide electrons to inhibit the spreading of copper filaments, such that the resistive random access memory can have better data retention capability. Moreover, the electron supply layer in the resistive random access memory can also be used to capture oxygen to stop oxygen from spreading to the atmosphere, such that the resistive random access memory can have better endurance.

## Claims

1. A resistive random access memory (100, 200), comprising:
a substrate (110);
a conductive layer (120) disposed on the substrate (110);
a resistive switching layer (130) disposed on the conductive layer (120);
a copper-containing oxide layer (140) disposed on the resistive switching layer (130); and
an electron supply layer (150) disposed on the copper-containing oxide layer (140).

2. The resistive random access memory (100, 200) of claim 1, wherein the conductive layer (120) comprises a single-layer structure or a multi-layer structure.

3. The resistive random access memory (100, 200) of claim 1, wherein a thickness of the conductive layer (120) is 1 nanometer to 500 nanometers.

4. The resistive random access memory (100, 200) of claim 1, wherein a thickness of the resistive switching layer (130) is 1 nanometer to 100 nanometers.

5. The resistive random access memory (100, 200) of claim 1, wherein a deposition temperature range of the resistive switching layer (130) is 100 °C to 500 °C.

6. The resistive random access memory (100, 200) of claim 1, wherein a material of the copper-containing oxide layer (140) comprises copper titanium oxide, copper tantalum oxide, copper aluminum oxide, copper cobalt oxide, copper tungsten oxide, copper iridium oxide, copper ruthenium oxide, copper nickel oxide, copper molybdenum oxide, copper zirconium oxide, or indium tin copper oxide.

7. The resistive random access memory (100, 200) of claim 1, wherein a thickness of the copper-containing oxide layer (140) is 1 nanometer to 100 nanometers.

8. The resistive random access memory (100, 200) of claim 1, wherein a material of the electron supply layer (150) comprises a copper-titanium alloy, copper titanium nitride, a copper-aluminum alloy, a copper-tungsten alloy, a copper-iridium alloy, copper iridium oxide, a copper-ruthenium alloy, a copper-tantalum alloy, copper tantalum nitride, a copper-nickel alloy, a copper-molybdenum alloy, a copper-zirconium alloy, or indium tin copper oxide.

9. The resistive random access memory (100, 200) of claim 1, wherein a thickness of the electron supply layer (150) is I nanometer to 1000 nanometers.

10. The resistive random access memory (100, 200) of claim 1, wherein the resistive random access memory (100, 200) further comprises a dielectric layer (160), wherein the dielectric layer (160) is disposed between the substrate (110) and the conductive layer (120).
